(19) Europäisches Patentamt
European Patent Office
Office européen des brevets

(11) EP 4 307 395 A1

(12) # EUROPEAN PATENT APPLICATION
published in accordance with Art. 153(4) EPC

(43) Date of publication:
**17.01.2024 Bulletin 2024/03**

(21) Application number: **21927033.7**

(22) Date of filing: **12.03.2021**

(51) International Patent Classification (IPC):
***H01L 31/0224*** *(2006.01)*

(52) Cooperative Patent Classification (CPC):
**H01L 31/022466; H01L 31/022408; H01L 31/022433; H01L 31/1884; H10K 30/83; H10K 50/814;** H01G 9/2009; H01G 9/2031

(86) International application number:
**PCT/JP2021/009945**

(87) International publication number:
**WO 2022/190336 (15.09.2022 Gazette 2022/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
- **KABUSHIKI KAISHA TOSHIBA Minato-ku Tokyo 105-0023 (JP)**
- **Toshiba Energy Systems & Solutions Corporation Kawasaki-shi, Kanagawa 212-0013 (JP)**

(72) Inventors:
- **NAITO, Katsuyuki Tokyo 105-0023 (JP)**
- **SHIDA, Naomi Tokyo 105-0023 (JP)**
- **GOTANDA, Takeshi Kawasaki-shi, Kanagawa 212-0013 (JP)**
- **SAITA, Yutaka Kawasaki-shi, Kanagawa 212-0013 (JP)**

(74) Representative: **Hoffmann Eitle Patent- und Rechtsanwälte PartmbB Arabellastraße 30 81925 München (DE)**

(54) **TRANSPARENT ELECTRODE, METHOD FOR PRODUCING SAME AND ELECTRONIC DEVICE USING TRANSPARENT ELECTRODE**

(57) Embodiments provide a transparent electrode having high stability, low sheet resistance, and high light transmissivity, a method for producing the transparent electrode, and an electronic device using the transparent electrode.

A transparent electrode including a structure including a transparent base material, a metal grid, metal nanowire, and a neutral polythiophene mixture. The metal grid has an embedded portion embedded in the transparent base material and a protrusion portion protruding from the transparent base material, and the metal nanowire and the neutral polythiophene mixture are arranged in contact with the transparent base material or the protrusion portion.

*Fig. 1*

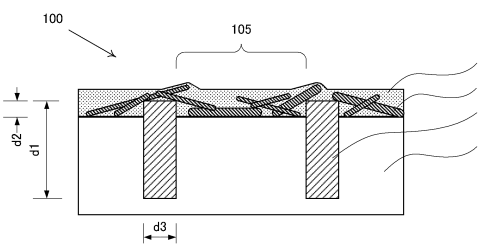


*Fig. 1*

EP 4 307 395 A1

## Description

### TECHNICAL FIELD

Embodiments of the present invention relate to a transparent electrode, a method for producing the same, and an electronic device.

### BACKGROUND ART

In recent years, energy consumption has been increasing, and there is an increasing demand for alternative energy to replace conventional fossil energy as a global warming countermeasure. Attention has been focused on a solar cell as a source of such alternative energy, and development of the solar cell has been in progress. Use of the solar cell for various applications has been investigated; however, flexibility and durability of the solar cell are particularly important in order to cope with various installation places. The most basic monocrystalline silicon-based solar cell is expensive and difficult to be made flexible, and organic solar cells and organic-inorganic hybrid solar cells that have recently attracted attention have room for improvement in terms of durability.

In addition to such a solar cell, photoelectric conversion elements such as an organic EL element and an optical sensor have been investigated for the purpose of flexibility and durability improvement. In such an element, a film of indium tin oxide (hereinafter, referred to as ITO) is widely used as a transparent positive electrode. The ITO film is typically formed by sputtering or the like. In order to obtain an ITO film having high conductivity, sputtering at a high temperature or high-temperature annealing after sputtering is required, and when an organic material is included in a base material or the like, the ITO film is often not applicable. In addition, the sheet resistance of the ITO film is about 10 Ω/□, and in order to produce a large-area solar cell, a fine strip-shaped scribe is often required in order to obtain higher conductivity.

### CITATION LIST

### PATENT LITERATURE

Patent Literature 1: Japanese Patent No. 6142870

### SUMMARY OF THE INVENTION

### OBJECT OF THE INVENTION

In view of the above problems, the present embodiment provides: a transparent electrode achieving a solar cell or a large-area illumination that is stable, has extremely small sheet resistance, is highly transmissive, and does not require fine scribing; a method for producing the transparent electrode; and an electronic device using the transparent electrode.

### SOLUTION TO PROBLEM

A transparent electrode according to an embodiment includes a structure including:

a transparent base material;
a metal grid;
a metal nanowire; and
a neutral polythiophene mixture,
wherein the metal grid includes an embedded portion embedded in the transparent base material and a protrusion portion protruding from the transparent base material, and
the metal nanowire and the neutral polythiophene mixture are arranged in contact with the protrusion portion of the transparent base material or the metal grid.

In addition, a method for producing a transparent electrode according to an embodiment, including:

(A) a step of preparing a temporary support;
(B) a step of arranging a metal grid on the temporary support;
(C) a step of embedding a part of the metal grid in the transparent base material;

(D) a step of separating the transparent base material from the temporary support, and arranging the metal grid on the transparent base material such that a remaining part of the metal grid forms a protrusion portion protruding from a surface of the transparent base material;
(E) a step of arranging metal nanowire into contact with the protrusion portion of the metal grid; and
(F) a step of arranging the neutral polythiophene mixture into contact with the protrusion portion of the metal grid.

In addition, the electronic device according to the embodiment includes the transparent electrode.

BRIEF DESCRIPTION OF DRAWINGS

FIG. 1 is a conceptual view showing a structure of a transparent electrode according to an embodiment.
FIG. 2 is a conceptual view showing a method of producing a transparent electrode according to an embodiment.
FIG. 3 is a conceptual view showing a structure of a photoelectric conversion element (solar battery cell) according to an embodiment.
FIG. 4 is a conceptual view showing a structure of a photoelectric conversion element (organic EL element) according to an embodiment.
FIG. 5 is a conceptual view showing a structure of a transparent electrode of Example 1.
FIG. 6 is a conceptual view showing a structure of a photoelectric conversion element (solar battery cell) of Example 5.
FIG. 7 is a conceptual view showing a structure of a photoelectric conversion element (solar battery cell) of Example 8.

BEST MODE FOR CARRYING OUT THE INVENTION

Hereinafter, embodiments will be described in detail with reference to the drawings.

[Embodiment 1]

A configuration of the transparent electrode according to the first embodiments will be described with reference to FIG. 1. FIG. 1 is a schematic configuration view of a transparent electrode 100 according to the present embodiment.
This transparent electrode 100 includes a structure including:

a transparent base material 101;
a metal grid 102;
a metal nanowire 103; and
a neutral polythiophene mixture 104.

As a material of the transparent base material 101, various resin materials can be used. Examples thereof include curable resin materials such as an epoxy resin, an acrylic resin, and a silicone resin, and thermoplastic resin materials such as polyethylene phthalate (PET) and polyethylene naphthalate (PEN). In particular, a material formed by curing a highly flowable monomer or oligomer is preferable from the viewpoint of production.
The thickness of the transparent base material is not particularly limited, and is, for example, 50 to 150 μm. In addition, the total transmittance of the transparent base material singly at 550 nm is preferably 85% or more.
The transparent electrode according to the embodiment includes a metal grid 102. This metal grid preferably has a thickness d1 of 5 to 50 μm, more preferably 15 to 30 μm. The metal grid 102 forms an embedded portion embedded in the transparent base material 101 and the protrusion portion protruding from the surface of the transparent base material. The height d2 of the protrusion portion is more than 0 μm, and is preferably 1 μm or less, more preferably 0.1 to 0.7 μm, and still more preferably 0.2 to 0.5 μm. A part of the metal grid is embedded in the transparent electrode, and therefore conductivity of the metal grid can be increased. In addition, the metal grid protrudes, thereby easily achieving electrical contact with the silver nanowire or electrical contact with another layer to be bonded in the case of producing an element.
The height of the protrusion portion of the metal grid can be measured by scanning the surface with using an atomic force microscope (AFM) or a contact type step profiler in a wider area. In the embodiment, as the height of the protrusion portion, an average value of measurement results is used at randomly selected five points.
When the thickness d1 of the metal grid 102 is 5 μm or more, the resistance of the metal grid wiring can be extremely reduced. In addition, it is easy to handle the metal foil. If the thickness is less than 5 μm, a back film tends to be required for handling, and the cost increases. Whereas, when the thickness d1 is 50 μm or less, sufficient conductivity is obtained, cost is suppressed, and patterning is also facilitated. When the height d2 of the protrusion portion of the

metal grid is 1 μm or less, such a small value of d2 makes it easy to prevent a short circuit in the case of producing an element by using the transparent electrode.

In addition, the line width d3 of the metal grid is adjusted based on the purpose, and is preferably 10 to 100 μm and preferably 20 to 50 μm. The line width of the metal grid is 10 μm or more, thereby allowing the sheet resistance of the transparent electrode to be reduced. In addition, the line width is 100 μm or less, thereby allowing the light transmittance of the transparent electrode to be increased. The values of d1, d2, and d3 are average values, respectively. The line width of the metal grid can be measured by a scanning electron microscope (SEM). In the embodiment, as the line width of the metal grid, an average value of measured values at five randomly selected points is used.

In the transparent electrode according to the present embodiment, the metal grid is preferably composed of copper, aluminum, silver, gold, tungsten, or an alloy thereof, and more preferably composed of copper or aluminum having a relatively small electric resistance. In addition, it is preferable to use these metal foils as raw materials because the metal grid can be easily produced.

An exposed portion 105 where the transparent base material is exposed is formed in a portion where no metal grid is arranged.

The transparent electrode according to the embodiment includes a metal nanowire. The metal nanowire is arranged in contact with an exposed surface of the transparent base material or the protrusion portion of the metal grid.

In the present embodiment, the metal included in the metal nanowire is not particularly limited, and from the viewpoint of conductivity and the like, a nanowire composed of a metal selected from the group consisting of silver, a silver alloy, copper, and a copper alloy is preferable, and a nanowire composed of a silver alloy is particularly preferable.

The plurality of metal nanowires are partially brought into contact with or fused with each other to form a network structure such as a network shape or a lattice shape. Thus, a plurality of conductive paths are formed, and a conductive cluster that is entirely connected is formed (percolation conductive theory). In order to enhance the conductivity of such conductive clusters, the density of the nanowire is preferably high. Whereas, in order to obtain an electrode used for an element requiring transparency and flexibility, it is preferable that the density of the nanowire is equal to or less than a certain value. Specifically, the application amount of the nanowire in the embodiment is commonly 0.05 to 50 $g/m^2$, preferably 0.1 to 10 $g/m^2$, and more preferably 0.15 to 1 $g/m^2$. The density of the metal nanowire is within this range, thereby allowing the resulting conductive film to simultaneously have sufficient transparency, flexibility, and conductivity.

In the present embodiment, the metal nanowire is typically composed of a metal nanowire having a diameter of 10 to 500 nm and a length of 0.1 to 50 μm. Generally, longer nanowire more easily forms conductive cluster and larger diameter nanowire is more conductive. As described above, the network structure is formed by using the nanowire, and therefore the conductive film including the nanowire exhibits high conductivity as a whole although the amount of metal is small.

When the diameter of the nanowire is too small, the electrical resistance of the nanowire itself tends to increase, and whereas when the diameter is too large, light scattering and the like may increase, leading to deterioration of transparency, and thus attention is required. In order to avoid these problems, the diameter of the nanowire is preferably 10 to 500 nm, more preferably 20 to 150 nm, and particularly preferably 30 to 120 nm.

When the length of the nanowire is too short, sufficient conductive clusters are not formed, and the electrical resistance tends to be high, and when the length of the nanowire is too long, dispersion in a solvent when an electrode or the like is produced tends to be unstable, and thus attention is required. In order to avoid these problems, the length of the nanowire is preferably 0.1 to 50 μm, more preferably 1 to 40 μm, and particularly preferably 5 to 30 μm. The diameter and length of the metal nanowire can be measured by, for example, analyzing an SEM image obtained by a scanning electron microscope (SEM). In the embodiment, the diameter and the length of the nanowire are average values of measured values for randomly selected five nanowires.

The transparent electrode according to the embodiment includes a neutral polythiophene mixture. This neutral polythiophene mixture is arranged in contact with an exposed surface of the transparent base material or the protrusion portion of the metal grid.

Polythiophene is a polymer of polythiophene or a derivative thereof, and has good conductivity, and thus is used in various electronic devices. In the embodiment, of these polythiophenes, neutral one is used. Polythiophene produces conductivity by doping. In general, in the production of an element, in the case of producing a transparent conductive film containing polythiophene, polythiophene and polystyrene sulfonic acid or the like as a doping agent are dispersed in water, a composition using a small amount of dimethyl sulfoxide as an additive is prepared, and the composition is heated for film formation to produce a transparent conductive film. However, the composition used in such a case is commonly acidic, and such a composition easily corrodes the metal grid or the metal nanowire. Various neutral polythiophene mixtures are known, for example, a polyamine salt of polysulfonic acid is used as a doping agent, and any neutral polythiophene mixture can be used from the neutral polythiophene mixtures depending on the purpose. In the embodiment, of these, those having a pH of 5 to 7 when made into an aqueous dispersion having a concentration of 1% by mass are preferable. As such a neutral polythiophene mixture, for example, a mixture of poly(3,4-ethylenedioxythiophene) and a guanidine salt of polystyrene sulfonic acid is preferably used.

The coating amount of the neutral polythiophene mixture in the embodiment is commonly 0.01 to 0.5 $g/m^2$, preferably 0.02 to 0.3 $g/m^2$, more preferably 0.05 to 0.2 $g/m^2$. The coating amount of the neutral polythiophene mixture is within this range, thereby allowing the resulting conductive film to simultaneously have sufficient transparency, flexibility, and conductivity.

In the transparent electrode according to the embodiment, both the metal nanowire and the neutral polythiophene mixture are in contact with the protrusion portion of the metal grid. An oxide is typically formed on the surface of the metal grid, and the contact resistance with the metal nanowire increases when the oxide is present. Therefore, it is preferable that the oxide is removed to expose the metal surface before the metal nanowire is brought into contact with the metal nanowire. That is, it is preferable to have a structure in which the metal surface of the metal grid and the metal nanowire are in contact with each other. A part of the molecules of the neutral polythiophene penetrate between the particles of the metal nanowire to form a mixed layer in which the metal nanowire and the neutral polythiophene mixture are mixed with each other, thereby increasing the conductivity of the mixed layer, and thus also increasing the conductivity of the transparent electrode. The neutral polythiophene mixture covers the metal nanowire and the metal grid, and therefore these are inhibited from being oxidized. In addition, the neutral polythiophene mixture has an effect of suppressing migration of metal. For this reason, for example, metal ions derived from the photoelectric conversion layer or the like included in the element hardly migrate to other layers, and the life of the element can be extended. Furthermore, the neutral polythiophene mixture tends to be easily adsorbed to a transparent substrate or a metal grid, and also exhibits an effect of compressing a metal nanowire layer. As a result, the contact area between the particles of the metal nanowire increases, and the conductivity of the transparent electrode also tends to increase.

The transparent electrode according to the embodiment exhibits excellent conductivity by including a structure having the metal grid, the metal nanowire, and the neutral polythiophene mixture described above, and the sheet resistance of the transparent electrode is preferably 0.01 to 1 Ω/□ and more preferably 0.05 to 0.2 Ω/□. When the sheet resistance of the transparent electrode is less than 0.01 Ω, light transmittance tends to be low. When it is more than 1 Ω, there is a tendency that a strip-shaped scribe is required in the case of constituting a large-area element.

In order to achieve such high conductivity, it is preferable to satisfy the following relationship: [sheet resistance of metal grid] < [sheet resistance of film composed of metal nanowire] < [sheet resistance of film composed of neutral polythiophene mixture]. Satisfying such a relationship can achieve high conductivity and high light transmittance over the entire transparent electrode. Herein, [sheet resistance of metal grid] is the sheet resistance of the composite of the transparent base material and the metal grid arranged thereon, [sheet resistance of film composed of metal nanowire] is the sheet resistance of the composite of the transparent base material and the metal nanowire arranged thereon, and [sheet resistance of film composed of the neutral polythiophene mixture] is the sheet resistance of the composite of the transparent base material and the neutral polythiophene mixture disposed thereon.

More specifically, the sheet resistance of the film made of metal nanowires is preferably 20 to 50 Ω/□, and the sheet resistance of the film composed of a neutral polythiophene mixture is preferably 100 to 500 Ω/□. The sheet resistance can be measured by using a four-probe method. In the embodiment, an average value of five randomly selected sheet resistance values is used as the sheet resistance.

When the sheet resistance of the film formed of the metal nanowire is 20 Ω or more, sufficient light transmittance tends to be obtained, and when the sheet resistance is 50 Ω or less, the sheet resistance of the entire transparent electrode tends to decrease.

When the sheet resistance of the film composed of a neutral polythiophene mixture is 100 Ω or more, sufficient light transmittance tends to be obtained, and when the sheet resistance is 500 Ω or less, the sheet resistance of the entire transparent electrode tends to be reduced.

In the transparent electrode according to the present embodiment, the open area ratio, which is the area ratio of the surface of the exposed portion 105 of the transparent base material based on the surface area of the transparent electrode, is preferably 90 to 99%. When the open area ratio is 90% or more, the light transmittance can be increased. Whereas, setting the open area ratio to 99% or less can increase the line width of the metal grid, and can reduce the sheet resistance.

In the transparent electrode according to the present embodiment, the average surface roughness of the surface of the exposed portion 105 of the transparent base material is preferably 10 nm or less. When the surface roughness of the exposed portion is 10 nm or less, uniformity and stability of an element formed on a transparent electrode tend to be improved in a case where an element having a large area is formed by using the transparent electrode according to the embodiment. The surface roughness of the exposed portion is more preferably 6 nm or less. The surface roughness can be measured by scanning the surface with using an atomic force microscope (AFM). In the embodiment, as the surface roughness, an average value of measured values for randomly selected five exposed portions of 5 μm square is used.

In addition, the transparent electrode according to the present embodiment preferably further includes a hydrophilic polymer film on the surface of the exposed portion 105 of the transparent base material. The surface of the exposed portion can be covered with a film having a relatively low surface roughness. In this case, if the surface of the

metal grid is subjected to a hydrophobic treatment with a surface treatment agent such as an alkyl thiol, the hydrophilic polymer is hardly covered with the metal grid portion. The length of the alkyl group of the alkyl thiol is preferably 2 to 12 carbon atoms. Alkyl thiols can be removed from the metal grid surface by washing with acid.

The transparent electrode according to the present embodiment preferably further includes a graphene layer on the surface of the protrusion portion of the metal grid, the surface of the metal nanowire, or the surface of the neutral polythiophene mixture.

In an embodiment, the graphene layer has a structure in which one to several layers of graphene having a sheet shape are laminated. The number of laminated graphene layers is not particularly limited, and is preferably 1 to 6, and more preferably 2 to 4, in order to allow obtaining sufficient transparency, conductivity, or ion shielding effect.

The graphene preferably has a structure in which, for example, a polyalkyleneimine, particularly a polyethyleneimine chain is bonded to a graphene skeleton as shown in the following formula, for example. In addition, the carbon of the graphene skeleton is preferably partially substituted with nitrogen.

[Chemical Formula 1]

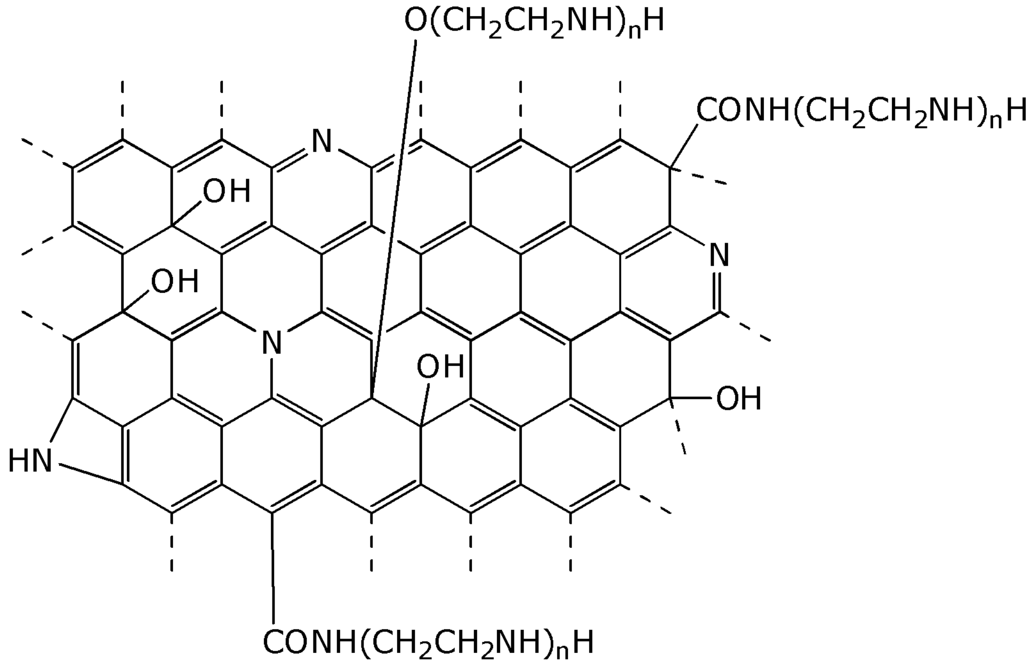

In the above formula, a polyethyleneimine chain is exemplified as a polyalkyleneimine chain. The number of carbon atoms included in the alkyleneimine unit is preferably 2 to 8, and polyethyleneimine including a unit having two carbon atoms is particularly preferable. In addition, there can be used not only the linear polyalkyleneimine but also a polyalkyleneimine having a branched chain or a cyclic structure. Herein, n (the number of repeating units) is preferably 10 to 1000, and more preferably 100 to 300.

The graphene is preferably unsubstituted or nitrogen-doped. Nitrogen-doped graphene is preferable when a transparent electrode is used as a cathode. The doping amount (N/C atomic ratio) can be measured by an X-ray photoelectron spectrum (XPS), and is preferably 0.1 to 30 atom%, and more preferably 1 to 10 atom%. The graphene layer has a high shielding effect, and thus can prevent diffusion of acid and halogen ions to prevent deterioration of metal oxides and metals, and prevent intrusion of impurities from the outside into the photoelectric conversion layer. Furthermore, the nitrogen-substituted graphene layer (N-graphene layer) includes a nitrogen atom, and therefore the trapping ability against an acid is also high and the shielding effect is higher.

In addition, in the embodiment, it is preferable to further include an inorganic oxide layer on the neutral polythiophene mixture or on the graphene layer. Examples of the inorganic oxide include $TiO_2$, $SnO_2$, $WO_3$, NiO, MoOs, ZnO, and $V_2O_5$. A conductive oxide may be further laminated. These inorganic oxide layers function as a barrier layer, an insulating layer, a buffer layer, and the like in a transparent substrate or an electronic device. The ratio of metal to oxygen atom in the inorganic oxide may not necessarily a stoichiometric ratio.

[Embodiment 2]

A method for producing the transparent electrode 100 according to the second embodiment shown in FIG. 2

includes:

(A) a step of preparing a temporary support 201;
(B) a step of arranging a metal grid 102 on the temporary support;
(C) a step of embedding a part of the metal grid in the transparent base material;
(D) a step of separating the transparent base material 101 from the temporary support 201, and arranging the metal grid 102 on the transparent base material 101 such that a remaining part of the metal grid 102 forms the protrusion portion protruding from the surface of the transparent base material 101;
(E) a step of arranging metal nanowire 103 into contact with the protrusion portion of the metal grid 102; and
(F) a step of arranging the neutral polythiophene mixture 104 into contact with the protrusion portion of the metal grid 102.

In the step (A), the temporary support 201 is prepared. This temporary support 201 is a support for temporarily arranging the metal grid, and can be selected from any material. As a material of the temporary support 201, glass, a resin film, metal, or the like is used.
In the step (B), the metal grid 102 is arranged on the surface of the prepared temporary support 201. This metal grid can be arranged by an optional method, for example:

(i) a method of attaching a metal foil onto the temporary support 201, and patterning the metal foil by a lithography method; or
(ii) a printing method or transfer method of using ink including metal on the temporary support 201. In any method, it is preferable to adjust the thickness of the metal foil, the amount of ink including metal arranged on the temporary support so that the thickness of the metal grid is 5 to 50 $\mu$m.

In the step (C), a part of the metal grid 102 formed on the surface of the temporary support 201 is embedded in the transparent base material 101. For example, as illustrated in FIG. 2 (C), pushing the metal grid 102 into the transparent base material 101 can embed a part of the metal grid, and thus the remaining portion can be used as a protrusion portion. In FIG. 2 (C), the temporary support 201 on which the metal grid 102 is arranged is reversed and pushed into the transparent base material 101. In this case, it is convenient to prepare a material for curing a monomer or oligomer having high fluidity to be a precursor of the transparent base material 101, immerse the metal grid 102 in the material, and then cure the material. In addition, a groove may be mechanically formed in a transparent base material having high hardness, and a metal grid may be fitted into the groove.
In the step (D), the temporary support is peeled off from the transparent base material 101. In this case, a remaining part of the metal grid 102 is a protrusion portion protruding from the surface of the transparent base material 101. As described above, when the transparent base material is formed by curing a highly flowable monomer or oligomer, shrinkage occurs in many cases during curing. In such a case, although the entire metal grid is embedded in the transparent base material precursor, a part of the metal grid can be protruded on the surface of the transparent base material along with shrinkage associated with curing of the transparent base material precursor. In this case, the height of the protrusion portion of the metal grid can be adjusted by controlling the temperature and time for curing the transparent base material. In addition, the temporary support and the transparent base material are easily peeled off due to shrinkage of the transparent base material, and therefore the temporary support may be peeled off after the transparent base material is cured.
After the step (D), an oxide may be formed on the surface of the metal grid 102, particularly on the protrusion portion. Such an oxide is preferably removed because of causing performance deterioration of the transparent electrode and the element. For example, after the metal grid is formed, the oxide on the surface of the metal grid can be removed by bringing a reducing agent such as hydrazine hydrate into contact with the surface of the transparent base material for reduction treatment or by washing with an acid.
In addition, after the step (D), the protrusion portion of the metal grid may be hydrophobized to produce a hydrophilic polymer film on the surface of the exposed portion of the transparent base material. Such a treatment reduces the roughness of the surface of the transparent base material before the metal nanowire is arranged, thereby easily improving the production yield and durability of the transparent electrode and the element.
After the step (D), in the step (E), the metal nanowire 103 is arranged in contact with the metal grid 102. In this step, commonly, a dispersion liquid including the metal nanowire 103 is applied to the surface of the transparent base material.
The dispersion liquid can include, for example, a polymer. The polymer functions as a binder for metal nanowires depending on the type, or can improve the adhesiveness between the conductive film and the transparent base material to suppress peeling of the conductive film. In the present embodiment, for example, an adhesive polymer can be used in such applications. Examples of such an adhesive polymer include a polyolefin into which a polar group is introduced,

an acrylic polymer, and a polyurethane-based polymer. However, when the blending amount of the polymer or the like in the conductive film is excessively high, the electrical resistance of the conductive film may be reduced. From such a viewpoint, the content of components other than the metal nanowires is preferably low. Specifically, the content of the metal nanowire included in the conductive film is preferably 95% by mass or more based on the total mass of the conductive film.

After the step (E), in the step (F), the neutral polythiophene mixture 104 is arranged into contact with the metal grid 102. In this step, generally, a solution or dispersion liquid including the neutral polythiophene mixture 104 is applied to the surface of the transparent base material on which the metal nanowires are arranged.

The coating liquid including the neutral polythiophene mixture includes water, ethanol, isopropyl alcohol, methyl ethyl ketone, and the like as a solvent or a dispersion medium.

In the present embodiment, either or both of the steps (E) and (F) can be performed by meniscus coating. In the present embodiment, an organic material film having high flexibility can be used as the transparent base material, and therefore the production efficiency can be enhanced by producing a transparent electrode by roll-to-roll in combination of coating methods.

In the method for producing a transparent electrode of the present embodiment, a step of forming a graphene layer can be further combined after the steps (D), (E), or (F).

The step of forming the graphene layer can be performed by optional method. For example, a method of forming a graphene film on another support and transferring the graphene film onto a structure can be used. Specifically, an unsubstituted single-layer graphene film is formed by a CVD method using a copper foil as a base catalyst layer using methane, hydrogen, or argon as a reaction gas, the film is pressure-bonded to an oxide film, and then copper is dissolved to allow transferring the single-layer graphene onto the structure. By repeating the same operation, a plurality of single-layer graphene can be laminated on the structure. In this case, it is preferable to produce 2 to 4 graphene layers. Instead of unsubstituted graphene, graphene in which a part of carbon is substituted with boron may be used. Boron-substituted graphene can be produced in the same manner by using $BH_3$, methane, hydrogen, or argon as a reaction gas.

In addition, the production method according to the embodiment may further include a step of forming an inorganic oxide layer after the step (F) or after the formation of the graphene layer. Examples of the inorganic oxide include $TiO_2$, $SnO_2$, $WO_3$, NiO, MoOs, ZnO, and $V_2O_5$. These inorganic oxide films are generally formed by a sputtering method, a vapor deposition method, a sol-gel method, or the like. The ratio of metal to oxygen atom in the inorganic oxide may not necessarily a stoichiometric ratio.

[Embodiment 3-1]

A configuration of the electronic device according to one of the third embodiments will be described with reference to FIG. 3. FIG. 3 is a schematic configuration view of a solar battery cell 300 (photoelectric conversion element) according to the present embodiment. The solar battery cell 300 is an element having a function as a solar battery that converts light energy such as the sunlight L incident on the cell into electric power. The solar battery cell 300 includes a photoelectric conversion layer 302 provided on a surface of the transparent electrode 301 and a counter electrode 303 provided on a side surface of the photoelectric conversion layer 302 opposite to the transparent electrode 301. Herein, the transparent electrode 301 is similar to that shown in Embodiment 1.

The photoelectric conversion layer 302 is a semiconductor layer that converts light energy of incident light into electric power to generate a current. The photoelectric conversion layer 302 generally includes a p-type semiconductor layer and an n-type semiconductor layer. There may be used, as the photoelectric conversion layer, a laminate of a p-type polymer and an n-type material, $RNH_3PbX_3$ (X represents a halogen ion, R represents an alkyl group and the like), a silicon semiconductor, an inorganic compound semiconductor such as InGaAs, GaAs, chalcopyrite, CdTe, InP, SiGe, or $Cu_2O$, a quantum dot-containing transparent semiconductor, and a dye-sensitized transparent semiconductor. In either case, the efficiency is high, and the degradation of the output can be further reduced.

A buffer layer may be inserted between the photoelectric conversion layer 302 and the transparent electrode 301 to promote or block charge injection.

The counter electrode 303 is typically an opaque metal electrode, and the transparent electrode according to the embodiment may be used. In addition, another charge buffer layer or charge transport layer may be inserted between the counter electrode 303 and the photoelectric conversion layer 302.

There can be used, as the buffer layer or the charge transport layer for a positive electrode, for example, a layer composed of vanadium oxide, PEDOT/PSS, a p-type polymer, vanadium pentoxide (V2O5), 2,2',7,7'-tetrakis[N,N-di(4-methoxyphenyl)amino]-9, 9 '-spirobifluorene (hereinafter, referred to as Spiro-OMeTAD), nickel oxide (NiO), tungsten trioxide ($WO_3$), or molybdenum trioxide (MoOs). The ratio of metal to oxygen atom in the inorganic oxide may not necessarily a stoichiometric ratio.

Whereas, there can be used, as the buffer layer or the charge transport layer for a transparent electrode serving as a negative electrode, a layer composed of lithium fluoride (LiF), calcium (Ca), 6,6'-phenyl-$C_{61}$-butyl acid methyl ester

(6,6'-phenyl-$C_{61}$-butyric acid methyl ester, C60-PCBM), 6,6'-phenyl-$C_{71}$-butyl acid methyl ester (6,6'-phenyl-C71-butyric acid methyl ester, hereinafter referred to as C70-PCBM), indene-$C_{60}$ bis-adduct (hereinafter referred to as ICBA), cesium carbonate ($Cs_2CO_3$), titanium dioxide ($TiO_2$), poly[(9,9-bis(3'-(N,N-dimethylamino)propyl)-2,7-fluorene)-alt-2,7-(9,9-dioctyl-fluorene)] (hereinafter, referred to as PFN), Bathocuproine (hereinafter referred to as BCP), zirconium oxide (ZrO), zinc oxide (ZnO), tin oxide ($SnO_2$), or polyethynimine. The ratio of metal to oxygen atom in the inorganic oxide may not necessarily a stoichiometric ratio.

An electrode having the same structure as the transparent electrode 301 may be used as the counter electrode 303. In addition, the counter electrode 303 may contain unsubstituted planar monolayer graphene. The unsubstituted monolayer graphene can be produced by a CVD method in which a copper foil is used as a base catalyst layer and methane, hydrogen, or argon as a reaction gas. For example, a thermal transfer film and monolayer graphene are pressure-bonded, then copper is dissolved, and the monolayer graphene is transferred onto the thermal transfer film. Repeating the same operation can laminate a plurality of monolayer graphene on the thermal transfer film, and 2 to 4 layers of graphene layers are produced. A metal wiring for current collection is printed on this film by using a silver paste or the like, whereby a counter electrode can be formed. Instead of unsubstituted graphene, graphene in which a part of carbon is substituted with boron may be used. Boron-substituted graphene can be produced in the same manner by using $BH_3$, methane, hydrogen, or argon as a reaction gas. These graphenes can also be transferred from a thermal transfer film onto a suitable substrate such as PET.

In addition, these monolayer or multilayer graphenes may be doped with a tertiary amine as an electron donor molecule. An electrode composed of such a graphene film also functions as a transparent electrode.

The solar battery cell according to the embodiment may have a structure in which both surfaces are sandwiched between transparent electrodes.

The solar battery cell having such a structure can efficiently utilize light from both surfaces. The energy conversion efficiency is generally 5% or more, and the solar battery cell is characterized by being stable and flexible for a long period of time.

As the counter electrode 303, an ITO glass transparent electrode can be used instead of the graphene film. In this case, flexibility of the solar battery cell is sacrificed; however, light energy can be used with high efficiency. In addition, there may be used, as a material of such a metal electrode, stainless steel, copper, titanium, nickel, chromium, tungsten, gold, silver, molybdenum, tin, or zinc. In this case, the transparency tends to decrease.

The solar battery cell can further include an ultraviolet cut layer and a gas barrier layer. Specific examples of the ultraviolet absorber include: benzophenone-based compounds such as 2-hydroxy-4-methoxybenzophenone, 2,2-dihydroxy-4-methoxybenzophenone, 2-hydroxy-4-methoxy-2-carboxybenzophenone, and 2-hydroxy-4-n-octoxybenzophenone; benzotriazole-based compounds such as 2-(2-hydroxy-3,5-di-tert-butylphenyl)benzotriazole, 2-(2-hydroxy-5-methylphenyl)benzotriazole, and 2-(2-hydroxy-5-tert-octylphenyl)benzotriazole; and salicylic acid ester-based compounds such as phenyl salicylate and p-octylphenyl salicylate. These desirably cut ultraviolet rays having 400 nm or less.

The gas barrier layer blocking particularly water vapor and oxygen is preferable, and a gas barrier layer that hardly passes water vapor is particularly preferable. For example, a layer composed of an inorganic material of SiN, $SiO_2$, SiC, $SiO_xN_y$, $TiO_2$, or $Al_2O_3$, ultra-thin glass, or the like can be preferably used. The thickness of the gas barrier layer is not particularly limited, and is preferably in the range of 0.01 to 3000 $\mu$m, and more preferably in the range of 0.1 to 100 $\mu$m. Sufficient gas barrier properties tend not to be obtained at less than 0.01 $\mu$m, and whereas, characteristics such as flexibility and softness tend to disappear due to an increase in thickness at more than 3000 $\mu$m. The water vapor transmission amount (moisture permeability) of the gas barrier layer is preferably 100 $g/m^2 \cdot d$ to $10^{-6}$ $g/m^2 \cdot d$, more preferably 10 $g/m^2 \cdot d$ to $10^{-5}$ $g/m^2 \cdot d$, and still more preferably 1 $g/m^2 \cdot d$ to $10^{-4}$ $g/m^2 \cdot d$. The moisture permeability can be measured in accordance with JIS Z0208 or the like. A dry method is preferable for forming a gas barrier layer. Examples of a method of forming a gas barrier layer having a gas barrier property by a dry method include: vacuum vapor deposition methods such as a resistance heating vapor deposition, an electron beam vapor deposition, an induction heating vapor deposition, and an assist method using a plasma or an ion beam; sputtering methods such as a reactive sputtering method, an ion beam sputtering method, or an electron cyclotron (ECR) sputtering method; a physical vapor deposition method (PVD method) such as an ion plating method; and a chemical vapor deposition method (CVD method) using heat, light, plasma, or the like. Of these, there is preferable the vacuum vapor deposition method in which a film is formed by a vapor deposition method under vacuum.

When the transparent electrode according to the embodiment includes a substrate, the type of the substrate is selected according to the purpose. Examples of the transparent substrate include an inorganic material such as glass, or an organic material such as PET, PEN, polycarbonate, or PMMA. In particular, use of a flexible organic material is preferable because the transparent electrode according to the embodiment is rich in flexibility.

The solar battery cell of the present embodiment can also be used as a photosensor.

[Embodiment 3-2]

A configuration of a photoelectric conversion element according to a third another embodiment will be described with reference to FIG. 4. FIG. 4 is a schematic configuration view of the organic EL element 400 (photoelectric conversion element) according to the present embodiment. The organic EL element 400 is an element having a function as a light emitting element that converts electric energy input to this element into light L. The organic EL element 400 includes a photoelectric conversion layer (light emitting layer) 402 provided on a surface of the transparent electrode 401, and a counter electrode 403 provided on a side surface of the photoelectric conversion layer 402 opposite to the transparent electrode 401.

Herein, the transparent electrode 401 is similar to that shown in Embodiment 1. The photoelectric conversion layer 402 is an organic thin film layer that recombines the charge injected from the transparent electrode 401 and the charge injected from the counter electrode 43 to convert electric energy into light. The photoelectric conversion layer 402 is typically composed of a p-type semiconductor layer and an n-type semiconductor layer. A buffer layer may be provided between the photoelectric conversion layer 402 and the counter electrode 403 to promote or block charge injection, and another buffer layer may also be provided between the photoelectric conversion layer 402 and the transparent electrode 401. The counter electrode 403 is typically a metal electrode; however, a transparent electrode may be used.

(Example 1)

A transparent electrode 500 having the structure shown in FIG. 5 is produced. A copper foil having a thickness of 20 μm is stuck on a PET film having a thickness of 100 μm. After the resist film is stuck, square grid-shaped wiring having a width of 20 μm is produced at a pitch of 2 mm by an optical lithography method. The open area ratio is 98%. Subsequently, the epoxy resin is applied and cured, and then peeled off from the PET film.

When observed by AFM, the copper wiring 502 is embedded in the epoxy resin 501, the thickness of the metal grid is about 20 μm corresponding to the film thickness of the copper foil, and the difference in protrusion portions is 0.5 μm on average.

Then, the copper oxide on the surface is removed by washing with 1 N hydrochloric acid and pure water and drying.

An aqueous dispersion of silver nanowires having an average diameter of 30 nm and a length of 5 μm is applied with a meniscus and then dried to produce a silver nanowire layer 503. The obtained film has an average sheet resistance of 0.2 Ω. The sheet resistance of the silver nanowire film similarly applied to the PET film is 40 Ω on average.

A pH 6.0 aqueous dispersion of neutral PEDOT (Clevios PJet) is applied with a meniscus onto the silver nanowire film to produce a PEDOT layer 504. After drying, the obtained film has an average sheet resistance of 0.2 Ω. When neutral PEDOT is similarly applied onto the silver nanowire film (sheet resistance is 40 Ω on average) of the PET film, the sheet resistance is 28 Ω on average, and the pressing effect by the PEDOT layer is observed.

In the AFM, the average roughness of the open areas of the copper grid is 6 nm.

(Comparative Example 1)

A transparent electrode is produced in the same manner as in Example 1 except for no step of removing copper oxide on the surface by washing with 1 N hydrochloric acid and pure water and drying. The obtained film has an average sheet resistance of 40 Ω measured with 4 probes, and the metal nanowire and the metal grid are not in contact with each other.

(Comparative Example 2)

A transparent electrode is produced in the same manner as in Example 1 except that the thickness of the copper foil to be attached to the PET film is 4 μm. The copper foil is thin and wrinkles are thus generated, failing to be attached uniformly, and making it difficult to form a grid having the embedded portion and the protrusion portion.

(Example 2)

The epoxy resin is cured under the condition of further relaxing the curing conditions of the epoxy resin as compared with the conditions in Example 1, and then peeled off from the PET film. When observed by AFM, the copper wiring is embedded in the epoxy resin, and the difference in height between the protrusion portions is 0.1 μm on average. A transparent electrode is produced in the same manner as in Example 1 except for the above.

The obtained transparent electrode film has a sheet resistance of 0.3 Ω on average, the variation is larger than

that in Example 1, and the contact between the metal nanowire and the metal grid is slightly inferior to that in Example 1.

(Example 3)

In Example 1, the epoxy resin is cured more quickly under strict curing conditions, and then peeled off from the PET film. When observed by AFM, the copper wiring is embedded in the epoxy resin, and the difference in height between the protrusion portions is 1.2 $\mu$m on average. A transparent electrode is produced in the same manner as in Example 1 except for the above. The obtained transparent electrode film has an average sheet resistance of 0.2 $\Omega$ as measured with four probes.

(Example 4)

There is formed, on the transparent electrode of Example 1, a shielding layer in which an average four layers of N-graphene each having a planar shape and having carbon atoms partially substituted with nitrogen atoms are laminated.

The shielding layer is formed as follows. The surface of the Cu foil is heat-treated by laser irradiation, and the crystal grains are enlarged by annealing. This Cu foil is used as a base catalyst layer, and ammonia, methane, hydrogen, and argon (15 : 60 : 65 : 200 ccm) are used as a mixed reaction gas at 1000°C for 5 minutes to produce a planar monolayer N-graphene film by a CVD method. In this case, a single-layer graphene film is mostly formed, and an N-graphene film having two or more layers is also partially formed depending on the conditions. Furthermore, treatment is performed at 1000°C for 5 minutes under an ammonia/argon mixed gas stream, and then cooling is performed under an argon stream. The monolayer N-graphene film is transferred onto the thermal transfer film by pressure-bonding the thermal transfer film (150 $\mu$m thick) and the monolayer N-graphene and then immersing in an ammonia alkaline cupric chloride etchant in order to dissolve Cu. Repeating the same operation laminated four layers of the monolayer graphene films on the thermal transfer film to provide a multilayer N-graphene film.

The thermal transfer film is laminated on the transparent electrode obtained in Example 1, and then heated to transfer the N-graphene film.

The nitrogen content measured by XPS is 1 to 2 atom% under this condition. The ratio between carbon atoms and oxygen atoms of the carbon material measured by XPS is 100 to 200.

(Example 5)

A solar battery cell 600 illustrated in FIG. 6 is produced.

A chlorobenzene solution including poly(3-hexylthiophene-2,5-diyl) and $C_{60}$-PCBM is applied with a meniscus onto the transparent electrode 601 obtained in Example 1, and dried at 100°C for 20 minutes to produce a photoelectric conversion layer 602. Then, a toluene solution of $C_{60}$-PCBM is applied with a meniscus and dried to produce an electron transport layer 603. Then, an aqueous solution of lithium fluoride is applied as an electron injection layer 604. Aluminum is vapor-deposited thereon to produce a counter electrode 605.

The ultraviolet cutting ink containing 2-hydroxy-4-methoxybenzophenone is screen-printed on the surface of the transparent substrate to produce an ultraviolet cutting layer 66. A silica film is formed on the ultraviolet cutting layer by a vacuum vapor deposition method to produce a gas barrier layer 67, and the whole is sealed with a film to produce a solar battery cell 60.

The resulting solar battery cell exhibits an energy conversion efficiency of 5% or more for 1 SUN of sunlight.

(Example 6)

A solar battery cell is produced in the same manner as in Example 5 except that the transparent electrode obtained in Example 3 is used.

The obtained solar battery cells are a mixture of those exhibiting an energy conversion efficiency of 5% or more with respect to 1 SUN of sunlight, and those exhibiting short-circuit.

(Example 7)

An organic EL element is prepared. An aqueous solution of lithium fluoride is applied onto the transparent electrode obtained in Example 4 as an electron transport layer, and tris(8-hydroxyquinoline)aluminum ($Alq_3$) (40 nm), which also functions as an n-type semiconductor and is a light emitting layer, is vapor-deposited to produce a photoelectric conversion layer. N,N'-di-1-naphthyl-N,N'-diphenyl-1,1'-biphenyl-4,4'-diamine (hereinafter, referred to as NPD) is vapor-deposited thereon in a thickness of 30 nm to produce a hole transport layer 83. A gold electrode is formed thereon by

a sputtering method. Furthermore, the periphery is sealed to produce an organic EL element. The obtained organic EL element has an efficiency of 20% or more.

(Example 8)

A solar battery cell is produced.

A titanium oxide film is produced on the transparent electrode obtained in Example 4 by sputtering. A solution of $PbI_2$ in isopropanol is applied with a meniscus. Then, a solution of methylammonium iodide in isopropanol is applied with a meniscus. A photoelectric conversion layer is produced by drying at 100°C for 10 minutes. Then, a toluene solution of Spiro-OMeTAD is applied with a meniscus and dried to produce a hole transport layer. An aqueous solution obtained by adding sorbitol to PEDOT/PSS is applied thereon and dried at 100°C for 10 minutes to produce a conductive adhesive layer.

Another transparent electrode obtained in Example 4 and the adhesive layer are bonded to each other.

The ultraviolet cutting ink containing 2-hydroxy-4-methoxybenzophenone is screen-printed on the surface of the transparent substrate bonded described above to produce an ultraviolet cutting layer. A silica film is formed on the ultraviolet cutting layer by a vacuum vapor deposition method to produce a gas barrier layer, thereby producing a translucent solar battery cell.

The resulting solar battery cell exhibits an energy conversion efficiency of 10% or more for 1 SUN of sunlight.

(Example 8)

A four-terminal tandem solar battery cell 700 illustrated in FIG. 7 is produced. In this tandem solar battery cell, a solar battery cell 703 including a transparent electrode 703a obtained in Example 7 according to the embodiment is arranged on a single crystal silicon solar battery cell 701 with an intermediate layer 702 for adhesion interposed therebetween.

The resulting solar battery cell exhibits an energy conversion efficiency of 22% or more for 1 SUN of sunlight.

As described above, some embodiments have been described, and these embodiments have been presented as examples, and are not intended to limit the scope of the invention. These novel embodiments can be implemented in various other forms, and various combinations, omissions, substitutions, changes, and the like can be made without departing from the gist of the invention. These embodiments and modifications thereof are included in the scope and gist of the invention, and are included in the invention described in the claims and the equivalent scope thereof.

REFERENCE SIGNS LIST

| | |
|---|---|
| 100 | Transparent electrode |
| 101 | Transparent base material |
| 102 | Metal grid |
| 103 | Metal nanowire |
| 104 | Neutral polythiophene mixture |
| 105 | Exposed portion |
| 201 | Temporary support |
| d1 | Metal grid thickness |
| d2 | Difference in height between metal grid and open area |
| d3 | Line width of metal grid |
| 300 | Solar battery cell |
| 301 | Transparent electrode |
| 302 | Photoelectric conversion layer |
| 303 | Counter electrode |
| 400 | Organic EL element |
| 401 | Transparent electrode |
| 402 | Photoelectric conversion layer |
| 403 | Counter electrode |
| 500 | Transparent electrode |
| 501 | Epoxy resin |
| 502 | Copper wiring |
| 503 | Silver nanowire layer |

504 PEDOT layer
600 Solar battery cell
601 Transparent electrode
602 Photoelectric conversion layer
603 Electron transport layer
604 Electron injection layer
605 Counter electrode
606 Ultraviolet cutting layer
607 Gas barrier layer
700 Tandem solar battery cell
701 Single crystal silicon solar battery cell
702 Intermediate layer
703 Solar battery cell
703a Transparent electrode

**Claims**

**1.** A transparent electrode comprising a structure including:

a transparent base material;
a metal grid;
a metal nanowire; and
a neutral polythiophene mixture,
wherein the metal grid includes an embedded portion embedded in the transparent base material and a protrusion portion protruding from the transparent base material, and
the metal nanowire and the neutral polythiophene mixture are arranged in contact with the protrusion portion of the transparent base material or the metal grid.

**2.** The transparent electrode according to claim 1, wherein a thickness of the metal grid is 5 to 50 μm.

**3.** The transparent electrode according to claim 1 or 2, wherein a height of the protrusion portion is 1 μm or less.

**4.** The transparent electrode according to any one of claims 1 to 3, wherein a line width of the metal grid is 10 to 100 μm.

**5.** The transparent electrode according to any one of claims 1 to 4, wherein the neutral polythiophene mixture is a mixture of neutral polythiophene and a doping agent, and a pH of the neutral polythiophene mixture as a dispersion liquid in water having a concentration of 1% by mass is 5 to 7.

**6.** The transparent electrode according to any one of claims 1 to 5, wherein the neutral polythiophene is poly(3,4-ethylenedioxythiophene).

**7.** The transparent electrode according to any one of claims 1 to 6, wherein the transparent electrode has a sheet resistance of 0.01 to 1 Ω/□.

**8.** The transparent electrode according to any one of claims 1 to 7, which satisfies a following relationship:

[sheet resistance of the metal grid] < [sheet resistance of a film composed of the metal nanowire] < [sheet resistance of a film composed of the neutral polythiophene mixture].

**9.** The transparent electrode according to any one of claims 1 to 8, wherein an open area ratio, which is an area ratio of an exposed portion surface of the transparent base material based on a surface area of the transparent electrode, is 90 to 99%.

**10.** The transparent electrode according to any one of claims 1 to 9, wherein an average surface roughness of an exposed portion surface of the transparent base material is 10 nm or less.

**11.** The transparent electrode according to any one of claims 1 to 10, further comprising a graphene layer on a surface of a protrusion portion of the metal grid, a surface of the metal nanowire, or a surface of the laminated structure.

**12.** A method for producing a transparent electrode, comprising:

(A) a step of preparing a temporary support;
(B) a step of arranging a metal grid on the temporary support;
(C) a step of embedding a part of the metal grid in the transparent base material;
(D) a step of separating the transparent base material from the temporary support, and arranging the metal grid on the transparent base material such that a remaining part of the metal grid forms a protrusion portion protruding from a surface of the transparent base material;
(E) a step of arranging metal nanowire into contact with a protrusion portion of the metal grid; and
(F) a step of arranging a neutral polythiophene mixture into contact with a protrusion portion of the metal grid.

**13.** The production method according to claim 12, wherein the step (B) is performed by attaching a metal foil onto the temporary support and patterning the metal foil by a lithography method.

**14.** The production method according to any one of claims 12 and 13, further comprising, after step (B), a step of removing oxide on a surface of a protrusion portion of the metal grid.

**15.** The production method according to any one of claims 12 to 14, further comprising, after step (D), a step of hydrophobizing the metal grid protrusion portion to produce a hydrophilic polymer film on a surface of an exposed portion of the transparent base material.

**16.** The production method according to any one of claims 12 to 15, further comprising a step of forming a graphene layer.

**17.** An electronic device comprising the transparent electrode according to any one of claims 1 to 11.

**18.** The electronic device according to claim 17, comprising: the transparent electrode; a photoelectric conversion layer; and a counter electrode.

**19.** The electronic device according to claim 17 or 18, wherein the photoelectric conversion layer includes halogen ions.

**20.** The electronic device according to any one of claims 17 to 19, comprising the transparent electrode as a transparent electrode of a four-terminal tandem solar battery.

Fig. 1

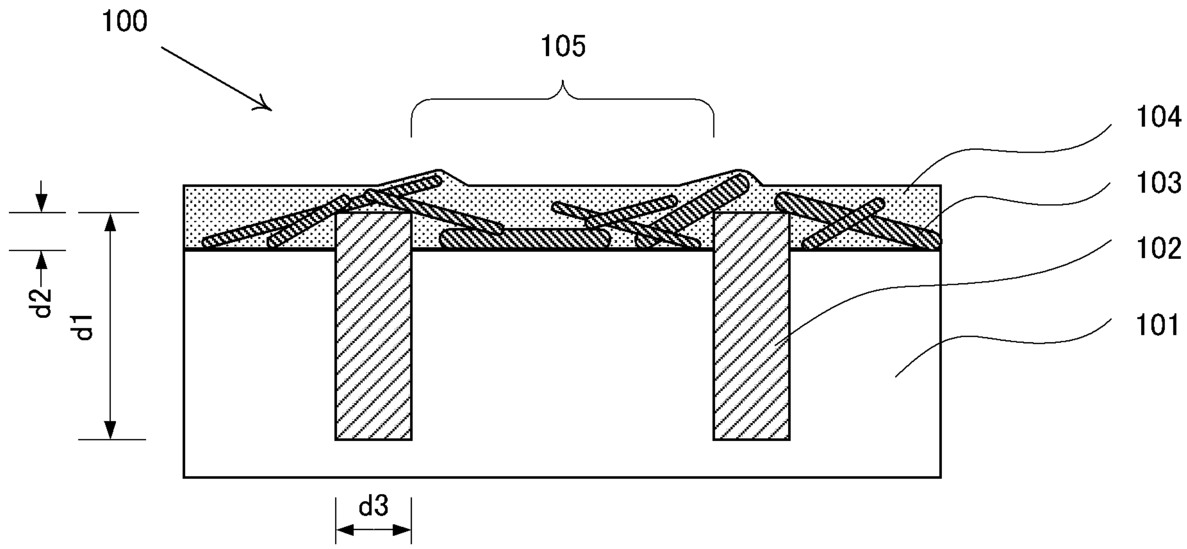


Fig. 1

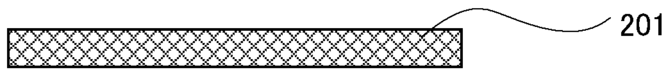


*Fig. 2(A)*

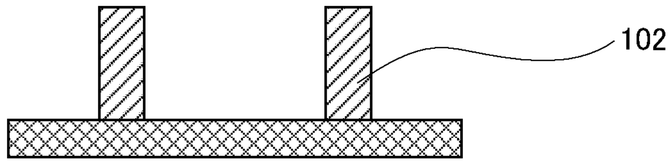


*Fig. 2(B)*

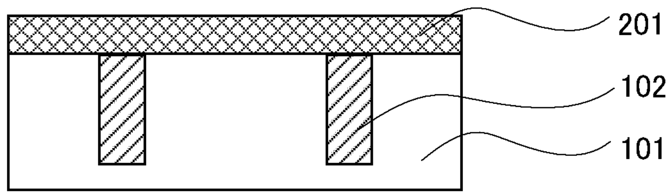


*Fig. 2(C)*

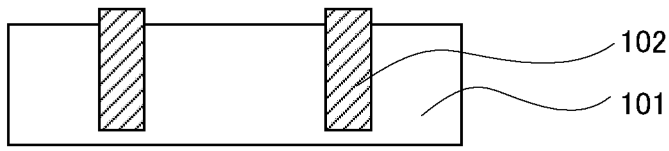


*Fig. 2(D)*

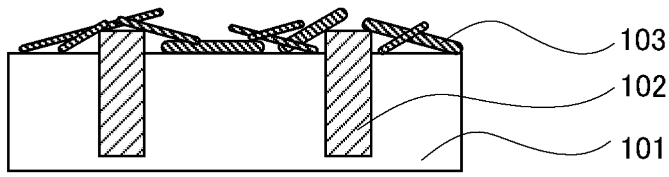


*Fig. 2(E)*

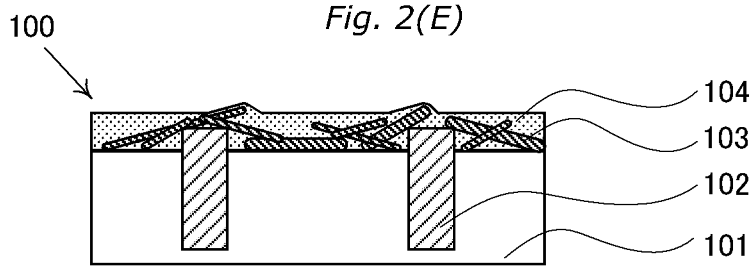


*Fig. 2(F)*

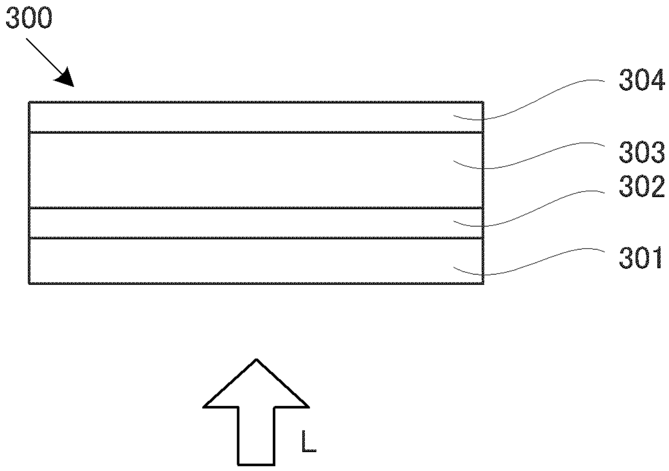


Fig. 3

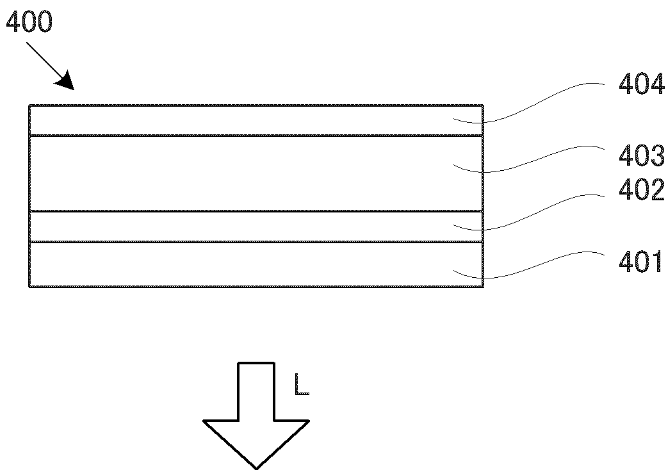


Fig. 4

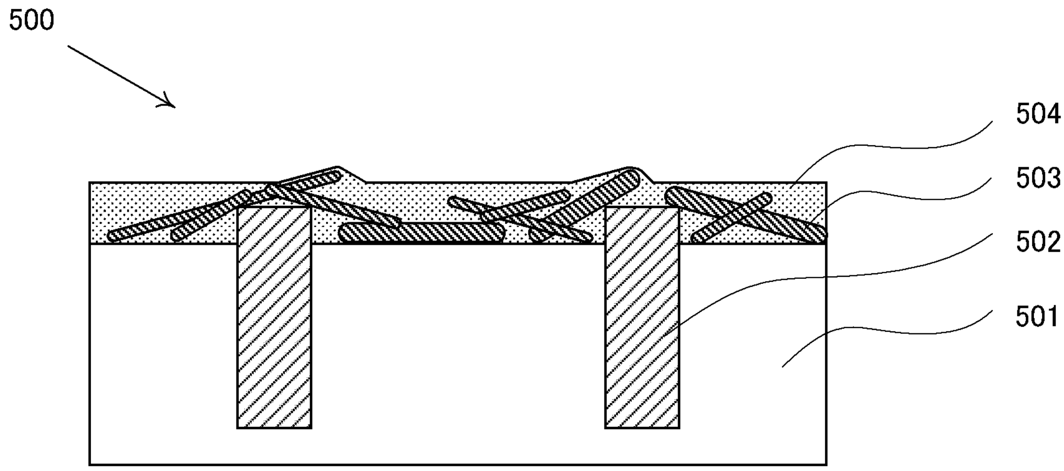


*Fig. 5*

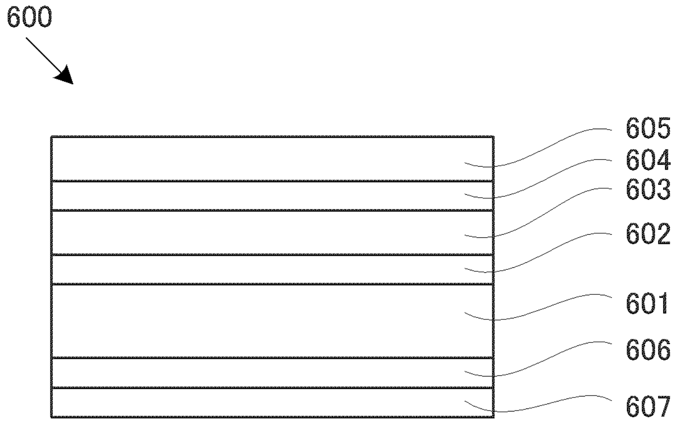


*Fig. 6*

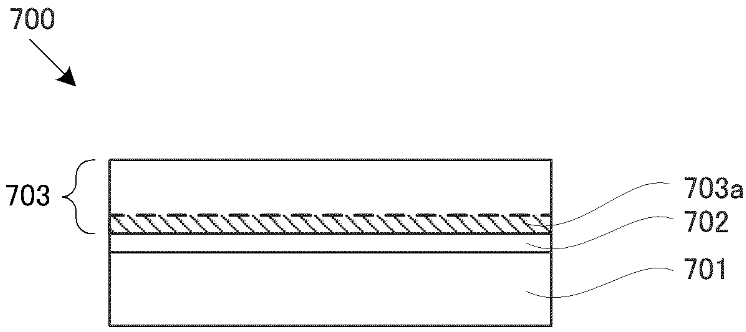


*Fig. 7*

## INTERNATIONAL SEARCH REPORT

International application No.
PCT/JP2021/009945

A. CLASSIFICATION OF SUBJECT MATTER
Int.Cl. H01L31/0224(2006.01)i
FI: H01L31/04266

According to International Patent Classification (IPC) or to both national classification and IPC

B. FIELDS SEARCHED

Minimum documentation searched (classification system followed by classification symbols)
Int.Cl. H01L31/0224, H05B33/28, H01B5/14

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | WO 2011/055663 A1 (KONICA MINOLTA HOLDINGS, INC.) 12 May 2011 (2011-05-12), claims 1-5, paragraphs [0036], [0041], [0056], [0076], [0085]-[0111], [0113], [0127], [0155], fig. 1, 2 | 1-13, 16-20<br>14-15 |
| Y | JP 2011-116925 A (NIHON SENTAN KAGAKU KK) 16 June 2011 (2011-06-16), abstract, paragraphs [0001]-[0033] | 1-13, 16-20 |
| Y | JP 2011-157535 A (NIHON SENTAN KAGAKU KK) 18 August 2011 (2011-08-18), abstract, paragraphs [0009]-[0056] | 1-4, 6-13, 16-20 |
| Y | WO 2012/093530 A1 (LINTEC CORP.) 12 July 2012 (2012-07-12), paragraphs [0011], [0012] | 9 |
| Y | JP 2017-80951 A (NITTO DENKO CORPORATION) 18 May | 10 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 14 May 2021 | 01 June 2021 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2021/009945

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2013-542546 A (WILLIAM MARSH RICE UNIVERSITY) 21 November 2013 (2013-11-21), fig. 1C | 11, 16 |
| Y | WO 2010/001591 A1 (TODA KOGYO CORPORATION) 07 January 2010 (2010-01-07), paragraphs [0002]-[0004] | 13 |
| Y | US 2018/0248052 A1 (KOREA RESEARCH INSTITUTE OF CHEMICAL TECHNOLOGY) 30 August 2018 (2018-08-30), paragraphs [0130], [0165]-[0167], [0481]-[0484] | 17-20 |
| A | JP 2012-80091 A (FUJIFILM CORP.) 19 April 2012 (2012-04-19), entire text, all drawings | 1-15 |

Form PCT/ISA/210 (second sheet) (January 2015)

**INTERNATIONAL SEARCH REPORT**
Information on patent family members

International application No.
PCT/JP2021/009945

| | | |
|---|---|---|
| WO 2011/055663 A1 | 12 May 2011 | (Family: none) |
| JP 2011-11925 A | 16 June 2011 | (Family: none) |
| JP 2011-157535 A | 18 August 2011 | (Family: none) |
| WO 2012/093530 A1 | 12 July 2012 | US 2013/0320322 A1<br>paragraphs [0038], [0039]<br>EP 2662865 A1<br>CN 103348417 A<br>KR 10-2014-0015290 A<br>TW 201236862 A |
| JP 2017-80951 A | 18 May 2017 | WO 2017/073316 A1<br>TW 201728450 A |
| JP 2013-542546 A | 21 November 2013 | US 2013/0048339 A1<br>fig. 1C<br>WO 2011/112589 A1<br>EP 2545561 A1<br>CN 103038835 A<br>KR 10-2013-0038836 A |
| WO 2010/001591 A1 | 07 January 2010 | US 2011/0143077 A1<br>paragraphs [0002]-[0004]<br>EP 2302645 A1<br>CN 102067245 A<br>KR 10-2011-0025914 A |
| US 2018/0248052 A1 | 30 August 2018 | EP 3244455 A1<br>KR 10-2016-0085720 A<br>CN 107431128 A |
| JP 2012-80091 A | 19 April 2012 | WO 2012/033103 A1 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6142870 B